(19) Europäisches Patentamt / European Patent Office / Office européen des brevets

(11) **EP 2 424 115 B1**

(12) **EUROPEAN PATENT SPECIFICATION**

(45) Date of publication and mention
of the grant of the patent:
**08.03.2017 Bulletin 2017/10**

(51) Int Cl.:
*H03M 3/00* (2006.01)     *H04L 25/49* (2006.01)

(21) Application number: **10305907.7**

(22) Date of filing: **23.08.2010**

(54) **A method for pulse length modulation of signals using calibration signals, and a modulation device therefor**

Verfahren und Vorrichtung zur Pulslängenmodulation unter Verwendung von Kalibrierungssignalen

Procédé et dispositif de modulation d'impulsions en durée utilisant des signaux de calibrage

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(43) Date of publication of application:
**29.02.2012 Bulletin 2012/09**

(73) Proprietor: **ALCATEL LUCENT**
**92100 Boulogne-Billancourt (FR)**

(72) Inventors:
• **Haslach, Christoph**
**70178 Stuttgart (DE)**
• **Maier, Simone**
**70565 Stuttgart (DE)**

(74) Representative: **Kleinbub, Oliver et al**
**Alcatel-Lucent Deutschland AG**
**Intellectual Property & Standards**
**Lorenzstrasse 10**
**70435 Stuttgart (DE)**

(56) References cited:
**GB-A- 2 456 889     US-A1- 2006 197 590**

## Description

### Field of the invention

The invention relates to a method for pulse length modulation of signals using calibration signals, and a modulation device adapted to perform said method.

### Background

In order to support highly efficient switching power amplifiers, signals with continuous amplitude, or multi-level signals, need to be converted to 2-level signals. In general, this transformation is executed by so-called delta sigma modulators (DSM), also called sigma delta modulators, or pulse length modulators (PLM), also called pulse width modulators.

These so-called pulse length modulators (PLM) are promising modulator concepts e.g. for highly efficient class-S power amplifiers used for the amplification of radio signals to be transmitted over an air interface in a communication network. In principle, they allow for an ideal conversion of signals with continuous amplitude and limited bandwidth to a time continuous 2-level signal. This 2-level signal is perfectly suited for switching amplifier stages. The 2-level signal can be reconverted to the continuous amplitude signal simply by a reconstruction filter after the amplification stage.

Further applications of pulse length modulators comprise the control of the supply of electrical power for other devices such as in speed control of electric motors, fundamental operation of so-called class-D audio switching amplifiers or bright-ness control of light sources.

In the patent application US 2006/0197590 A1, a class-D power amplifier is disclosed comprising a first pulse width modulator for generating a PWM signal Vi according to an input signal Vd, a power stage for generating an output signal Vo according to a control signal Vi', a subtracting unit for producing an error signal Ve' according to the PWM signal Vi and the output signal Vo, a noise shaping module for producing a noise-shaped signal according to the error signal ve', an adding unit for summing the noise-shaped signal and the input signal Vd to produce a calibration signal, and a second pulse width modulator for generating the control signal Vi'.

### Summary

There are several architectures to implement pulse length modulators. In principle, an analogue implementation works as described in the following.

A signal with a continuous amplitude is fed to a comparator as a first input signal. The second input signal to the comparator is a sawtooth signal. As soon as the ascending amplitude of the sawtooth signal has the same value as the continuous amplitude signal, the output of the comparator switches from voltage-high (VH) to voltage-low (VL). The falling edge of the sawtooth signal resets the output of the comparator to voltage high (VH). The output of the comparator is the PLM signal.

Depending on the implementation, the first input of the comparator may also be the sampled version of the continuous amplitude signal, sampled at equidistant time instances. Due to ease of description, we will use this version in the following.

The lengths of the generated PLM-pulses shall be linearly proportional to the amplitude of the input signal samples. However, this is not really the case, e.g. due to non-ideal components, e.g. for generating the sawtooth signal or due to a non-ideal comparator.

E.g., depending on the high sampling frequencies required, the sawtooth signal can only be generated in a suboptimal way, e.g. due to bandwidth limitations. This may result in a flattening of the sawtooth waveform.

Such distortions have severe impact on the signal quality, leading e.g. to an increase of the error vector magnitude (EVM) or a violation of the spectrum mask.

The object of the invention is thus to propose a method for pulse length modulation of signals with an increased signal quality, and is achieved by the method as presented in claim 1.

In an embodiment of the invention, the data path and the calibration path are interchanged in order to average slight differences in the characteristics of the first and the second pulse length modulator caused e.g. by allowed fabrication tolerances. Alternatively, by means of interchanging the data path and the calibration path, exact precompensation values can be determined for both paths and said exact precompensation values can be used for the respective path. The data path and the calibration path can be interchanged e.g. after every modulation pulse or after a predefined number of modulation pulses. Preferably, the data path and the calibration path are repeatedly interchanged in order to average differences in the time drift of the characteristics of the first and the second pulse length modulator. The data path and the calibration path can be interchanged e.g. by means of a switch.

In a preferred embodiment, the calibration signals are periodic sequences of equal signals in order to exploit simplified the measurement of periodic signals, e.g. in order to average measurement errors of the measured pulse length modulated calibration signals or e.g. to extract the spectral properties of the periodic signals.

In another preferred embodiment, the calibration signals are sequences of continuous wave signals with varying signal frequency in order to characterize the frequency response of the pulse length modulator, which can then be used for precompensation of the signals.

In an embodiment, the modulated calibration signals are used to generate precompensation data stored in a lookup table used to precompensate the signals in the data path. Said precompensation data are preferably stored in a preprocessor which is connected to the pulse length modulator in the data path.

In another embodiment, the modulated calibration signals are used to generate a precompensation function used to precompensate the signals in the data path. Said precompensation function is preferably stored in a preprocessor which is connected to the pulse length modulator in the data path.

In a further embodiment, the calibration signals are selected based on the time passed since the last determination of precompensation values for the different signal values. In other words, signal values which have not been used as calibration signals for a long time are preferably used as calibration signals in order to avoid that the outdating of precompensation values becomes too big.

In a yet further embodiment, the calibration signals are precompensated in the calibration path before pulse length modulation is performed in order to determine a precompensation value which is closer to the desired calibration signal.

The object is furthermore achieved by a modulation device as presented in claim 12.

Further features and advantages are stated in the following description of exemplary embodiments, with reference to the figures of the drawing, which shows significant details, and are defined by the claims. The individual features can be implemented individually by themselves, or several of them can be implemented in any desired combination.

The present invention is defined and limited only by the scope of appended claims 1-15.

**Brief description of the figures**

In the following the invention will be explained further making reference to the attached drawings.

Fig. 1 schematically shows a pulse length modulator according to the state of the art.

Fig. 2 schematically shows input signals, output signals and ideal sawtooth signals of a pulse length modulator according to the state of the art.

Fig. 3 schematically shows an input signal, an output signal and a non-ideal sawtooth signal of a pulse length modulator according to the state of the art.

Fig. 4 schematically shows a modulation device comprising two pulse length modulators according to an embodiment of the invention.

Fig. 5 schematically shows exemplarily the pulse length after modulation plotted against the input signal level for pulse length modulation with and without distortions.

Fig. 6 schematically shows exemplarily pulse length modulated signals of the calibration path of four different calibration signals according to an embodiment of the invention.

Fig. 7 schematically shows exemplarily mean power and mean signal level of periodic pulse length modulated signals with distortions.

Fig. 8 schematically shows exemplarily a switched mode power amplifier with a modulation device according to an embodiment of the invention, a switched output stage and a filter.

**Description of the embodiments**

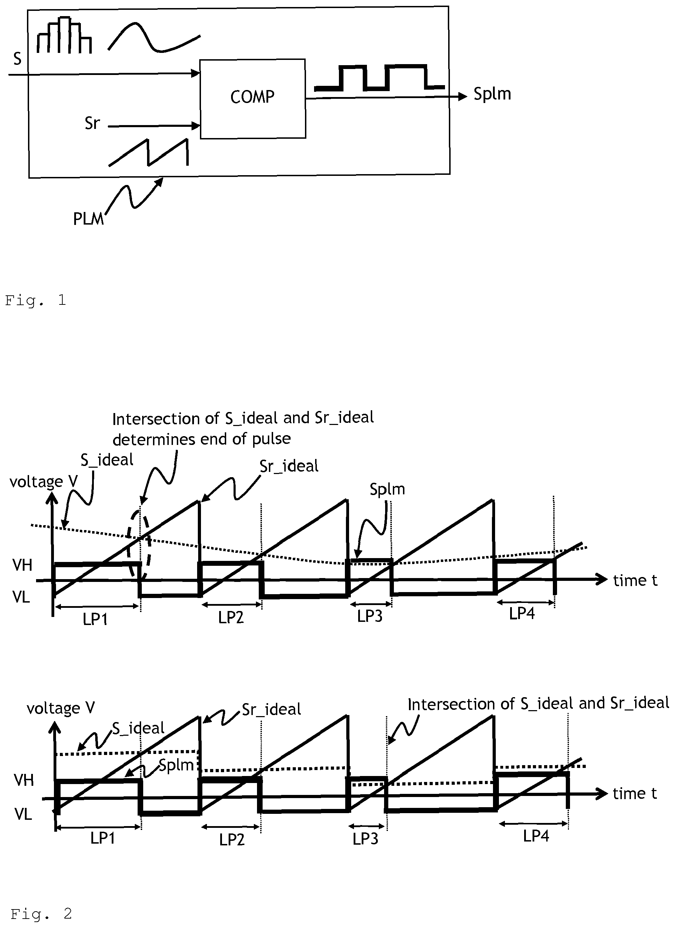

Fig. 1 schematically shows a pulse length modulator PLM according to the state of the art comprising as a basic part a comparator COMP with two inputs and one output.

Depending on the implementation, the input signal S of the pulse length modulator PLM can either be a signal with continuous amplitude, or the sampled version of the continuous amplitude signal, sampled at equidistant time instances.

The input signal S is fed to the first input of the comparator COMP, and a sawtooth signal Sr is fed to the second input of the comparator COMP. The pulse length modulated signal Splm is transmitted from the output of the comparator COMP to the output of the pulse length modulator PLM.

Fig. 2 schematically shows such input signals S_ideal, output signals Splm and ideal sawtooth signals Sr_ideal of a pulse length modulator according to the state of the art as depicted in fig. 1.

In the upper diagram in fig. 2, the voltage V of a continuous amplitude input signal S_ideal, a pulse modulated output signal Splm and an ideal sawtooth signal Sr_ideal are plotted against the time t.

In the lower diagram in fig. 2, the voltage V of a sampled version of the continuous amplitude input signal S_ideal, a pulse modulated output signal Splm and an ideal sawtooth signal Sr_ideal are plotted against the time t.

As soon as the ascending amplitude of the sawtooth signal Sr_ideal has the same value as the continuous amplitude input signal S_ideal, or as the the sampled version of the continuous amplitude input signal S_ideal, the output of the comparator COMP in fig. 1 switches from voltage-high VH to voltage-low VL. The falling edge of the sawtooth signal Sr_ideal resets the output of the comparator COMP to voltage-high VH. The output signal of the comparator COMP is the PLM signal SPLM comprising pulses of different length LP1-LP4.

Due to ease of description, embodiments with sampled input signals will be used in the following.

The lengths LP1-LP4 of the generated PLM pulses Splm shall be linearly proportional to the amplitude of the signal samples of the input signal S_ideal. Actually, this is not really the case due to non-ideal components, e.g. for generating the sawtooth signal Sr_ideal or due to a non-ideal comparator. E.g. depending on the high sampling frequencies required, the sawtooth signal Sr_ideal can only be generated in suboptimal way, e.g. due to bandwidth limitations. This may e.g. result in a flattening of the sawtooth waveform.

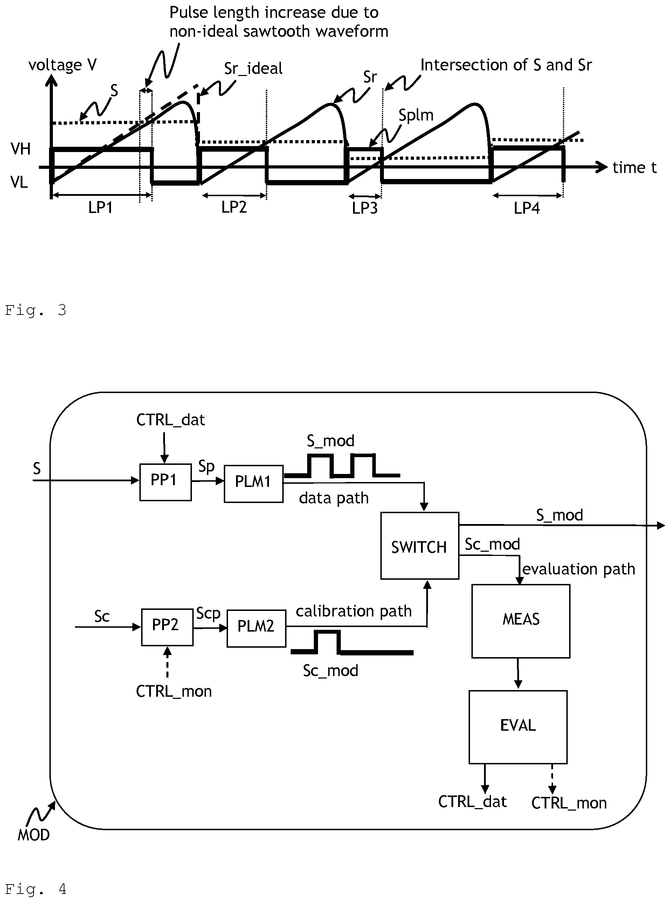

Fig. 3 schematically shows an input signal S, a pulse modulated output signal Splm and such a non-ideal sawtooth signal Sr of a pulse length modulator according to the state of the art.

In fig. 3, exemplarily the pulse length increase of the first pulse with a length of LP1 due to a flattened non-ideal sawtooth signal waveform Sr is depicted. In other words, the pulse length increase is caused by the difference between the ideal sawtooth waveform Sr_ideal and the non-ideal sawtooth waveform Sr.

Other reasons for distortions of the pulse length of the pulse length modulated signals are e.g. aging or temperature effects of pulse length modulators.

Such distortions of the pulse length of the pulse length modulated signals have severe impact on the signal quality, as they lead e.g. to an increase of the error vector magnitude (EVM) or to a violation of the spectrum mask.

One solution to correct such distortions of the pulse length is to measure the pulse length by oversampling of the pulse length modulated output signal, and to use the measured pulse length error for a precompensation of the input signal. In order to achieve an exact measurement of the pulse length, the output of the pulse length modulator, or a part of it by using a splitter or a coupler, is sampled with a high sampling rate. Evaluating these sample values, yields a measure for the actual pulse length.

However, said solution requires a high sampling rate and should be avoided in practice. Hence, according to an embodiment of the invention, an alternative solution employing energy or power measurement of pulse modulated signals is proposed which is exemplarily described in the following.

Fig. 4 schematically shows a modulation device MOD comprising two pulse length modulators PLM1, PLM2 according to an embodiment of the invention.

The modulation device MOD comprises two preprocessors PP1, PP2, two pulse length modulators PLM1, PLM2, a switch SWITCH, a measurement device MEAS, and an evaluation device EVAL. The two pulse length modulators PLM1, PLM2 should be of same or similar kind for the method according to the invention to work properly.

An input signal path of the modulation device MOD is connected to a first input of the first preprocessor PP1 in a data path.

In the data path, an output of the first preprocessor PP1 is connected to an input of the first pulse length modulator PLM1, which is in turn connected to a first input of the switch SWITCH.

In a calibration path, the second preprocessor PP2 comprises a first input for the input of calibration signals Sc. An output of the second preprocessor PP2 is connected to an input of the second pulse length modulator PLM2, which is in turn connected to a second input of the switch SWITCH.

A first output of the switch SWITCH is connected to an output of the modulation device MOD.

A second output of the switch SWITCH is connected to an input of the measurement device MEAS, and an output of the measurement device MEAS is connected to an input of the evaluation device EVAL.

A first output of the evaluation device EVAL is connected to a second input of the first preprocessor PP1, and a second output of the evaluation device EVAL is connected to a second input of the second preprocessor PP2.

An input signal S received at the input of the modulation device MOD is transmitted to the first preprocessor PP1 in the data path.

The input signal S is precompensated in the first preprocessor PP1 e.g. by means of lookup table or a precompensation function correlating the first input signal S to a corrected, i.e. precompensated input signal Sp.

The precompensated input signal Sp is fed to the input of the first pulse length modulator PLM1, in which pulse length modulation of the precompensated input signal Sp is performed as described above.

The pulse length modulated input signal S_mod is fed to the first input of the switch SWITCH.

In the calibration path, the calibration signal Sc is precompensated in the second preprocessor PP2 e.g. by means of a lookup table or a precompensation function correlating the calibration signal Sc to a corrected, i.e. precompensated calibration signal Scp.

The precompensated calibration signal Scp is fed to the input of the second pulse length modulator PLM2, in which pulse length modulation of the precompensated calibration signal Scp is performed as described above.

The pulse length modulated calibration signal Sc_mod is fed to the second input of the switch SWITCH.

In the switch SWITCH, the pulse length modulated input signal S_mod from the data path is switched to the output of the modulation device MOD, and the pulse length modulated calibration signal Sc_mod from the calibration path is switched to the measurement device MEAS in an evaluation path.

Measurement of e.g. power or energy of the pulse length modulated calibration signal Sc_mod in the measurement device MEAS gives information on the actual pulse length e.g. of a single pulse of the pulse length modulated calibration signal Sc_mod. E.g. by measuring the power of the single pulse, and as the signal level VH is known, the actual pulse length can be determined. Thus, oversampling of the pulse length modulated output signal requiring a high sampling rate can be avoided.

The measurement results, as e.g. information on the actual pulse length e.g. of the single pulse, are fed to the evaluation device EVAL, in which the actual pulse length is related to an input signal S_ideal in case of an ideal, error-free pulse length modulation.

As the level of the precompensated calibration signal Scp applied to the second pulse length modulator PLM2 is provided to the evaluation device EVAL, and is thus known in the evaluation device EVAL, it can be derived in the evaluation device EVAL, which precompensated calibration signals Scp must be applied to the second pulse length modulator PLM2 to get a pulse length related to an input signal S_ideal. In other words, a precompensation of the input signal S can be performed if it is assumed that the first and the second pulse length modulator PLM1 and PLM2 have similar characteristics.

Said relation between the input signal S_ideal for an error-free pulse length modulation, and the precompensated input and calibration signals Sp, Spc applied to the first and second pulse length modulators PLM1, PLM2 can be e.g. stored in a lookup table, or a precompensation function can be generated which relates the input signal S_ideal and the precompensated input and calibration signals Sp, Scp.

Said lookup table or said precompensation function is e.g. implemented in the first and second preprocessors PP1, PP2, and is updated by means of control information CTRL_dat, CTRL_mon sent from the evaluation device EVAL to the first and second preprocessor PP1, PP2 respectively.

In an embodiment of the invention, the calibration signals Sc in the calibration path are not precompensated in the second preprocessor PP2, but directly pulse length modulated in the second pulse length modulator PLM2. Thus, in this embodiment, there is no second preprocessor PP2 needed, and also no control information CTRL_mon is transmitted from the evaluation device EVAL.

In another embodiment, the calibration signals Sc are generated in an external device, which is not depicted in fig. 4, and transmitted to the calibration path via a further input of the modulation device MOD.

In a further embodiment of the invention, the calibration signals Sc are generated internally in the modulation device MOD. The calibration signals Sc can e.g. be generated in the evaluation device EVAL and can be comprised in the control information CTRL_mon sent from the evaluation device EVAL to the second preprocessor PP2.

In an embodiment of the invention, the calibration signal Sc can be a direct current (DC) signal so that the actually measured power of the pulse length modulated calibration signal Sc_mod can be compared to the known signal power of the DC signal, and thus precompensation data stored e.g. in a lookup table in the first preprocessor PP1 can be adjusted. By slowly varying the DC amplitude, the correction levels for all required input amplitude levels can be derived. Instead of using a DC signal as calibration signal Sc, e.g. a continuous wave (CW) signal can be used, and by varying the signal frequency, the frequency response of the second pulse length modulator PLM2 can be characterized and used for calibration or precompensation purposes.

In an embodiment of the invention, the evaluation device EVAL can be integrated in the first and second preprocessor PP1, PP2 respectively, and the measurement results can be sent directly from the measurement device MEAS to the first and the second preprocessor PP1, PP2.

In a further embodiment of the invention, the data path and the calibration path are interchanged repeatedly by means of the switch SWITCH in order to equalize fabrication differences between the first and second pulse length modulator PLM1, PLM2 or the first and second preprocessor PP1, PP2. Preferably, the interchanging of data path and calibration path is supported by adding a switch prior to the first and the second preprocessor PP1 and PP2.

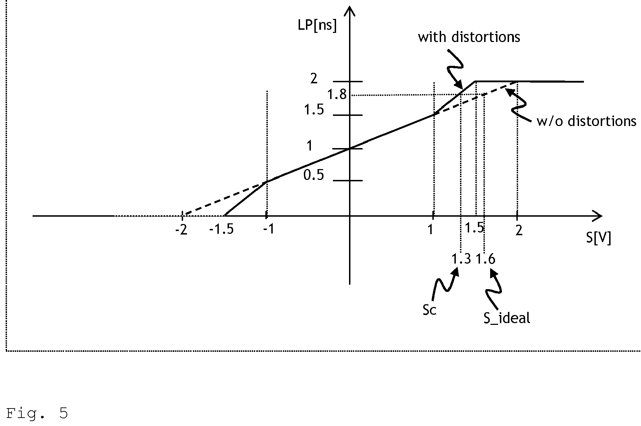

Fig. 5 schematically shows exemplarily the pulse length LP in ns after modulation, i.e. the time duration, when pulse has signal level voltage-high VH, plotted against the input signal level S in volts V for pulse length modulation with and without distortions performed e.g. in pulse length modulators PLM1 or PLM2 as depicted in fig. 4. It is assumed that the first and the second pulse length modulators PLM1, PLM2 are identical or at least similar, but suffer from non-linear mapping of pulse length and input signal level.

The dashed line in Fig. 5 indicates the pulse length after modulation without any distortions, i.e. in an ideal case, and the solid line indicates the pulse length after modulation with distortions caused e.g. by non-ideal sawtooth signals or due to aging or temperature effects.

The following formula describes the relation between the pulse length LP in ns after modulation to the input signal level S in volts V for pulse length modulation without distortions as depicted in fig. 5 by the dashed line:

$$LP = 1+(0.5*S)$$

The following formulae describe the relation between the pulse length LP in ns after modulation to the input signal level S in volts V for pulse length modulation with distortions as depicted in fig. 5 by the solid line:

$$LP = 1+(0.5*S) \quad for -1 \le S \le 1$$

$$LP = 0.5+S \quad for S > 1$$

$$LP = 1.5+S \quad for S < -1$$

$$for \ 0 \le LP \le 2 \ and -1.5 \le S \le +1.5$$

A precompensation of the input signal S yields a precompensated input signal Sp. The target is to precompensate the original input signal S in such a way, that the relation between the input signal S and the pulse length LP is linear, as depicted by the dashed line in fig. 5.

If e.g. an input signal of S = 1.6 V is pulse modulated, this would lead to a pulse length LP = 1.8 ns in case of an error-free pulse length modulation, as depicted in fig. 5. For the real case taking into account distortions, in order to achieve the desired pulse length of 1.8 ns, a precompensated input signal of 1.3 V has to be applied, which is also depicted in fig. 5. Thus, the input signal 1.6 V must be replaced by the precompensated input signal 1.3 V.

The relations between input signals and precompensated input signals can be e.g. stored in the first and second preprocessors PP1, PP2 as depicted in fig. 4 in the form of a precompensation function, or in the form of a lookup table.

Such a lookup table relating an input signal S with a precompensated input signal Sp which replaces the input signal S as input value for the first pulse length modulator PLM1 is calculated by means of the formulae for the cases with and without distortions given above and may look like the following table:

| input signal S [V] | -1.6 | -1.0 | 0 | 1.0 | 1.2 | 1.6 |
|---|---|---|---|---|---|---|
| precompensated signal Sp [V] | -1.3 | -1.0 | 0 | 1.0 | 1.1 | 1.3 |
| pulse length [ns] | 0.2 | 0.5 | 1.0 | 1.5 | 1.6 | 1.8 |

In the following, a process for determining and updating such a lookup table according to an embodiment of the invention is described.

In order to determine the lookup table, e.g. the following DC precompensated calibration signal sequences are transmitted in the calibration path:

Scp [V]= 0.6 0.6 0.6 0.6..., resulting in a sequence of periodic pulse widths of LP = 1.3ns.

Scp [V]= 1.0 1.0 1.0 1.0..., resulting in a sequence of periodic pulse widths of LP = 1.5ns.

Scp [V]= 1.3 1.3 1.3 1.3..., resulting in a sequence of periodic pulse widths of LP = 1.8ns.

Scp [V]= 1.5 1.5 1.5 1.5..., resulting in a sequence of periodic pulse widths of LP = 2.0ns and thus in a constant level VH, as 2.0ns shall be the maximum pulse length.

Scp [V]= -0.6 -0.6 -0.6 -0.6..., resulting in a sequence of periodic pulse widths of LP = 0.7ns.

Scp [V]= -1.0 -1.0 -1.0 -1.0..., resulting in a sequence of periodic pulse widths of LP = 0.5ns.

Scp [V]= -1.3 -1.3 -1.3 -1.3..., resulting in a sequence of periodic pulse widths of LP = 0.2ns.

Scp [V]= -1.5 -1.5 -1.5 -1.5..., resulting in a sequence of periodic pulse widths of LP = 0ns and thus in a constant level VL.

Said relation between the pulse lengths and the signal level of the precompensated calibration signal Scp can be used to determine e.g. a lookup table as depicted above.

The relation between input signals and precompensated input signals as described in such a lookup table shall be known in the first and second preprocessors PP1, PP2 as depicted in fig. 4.

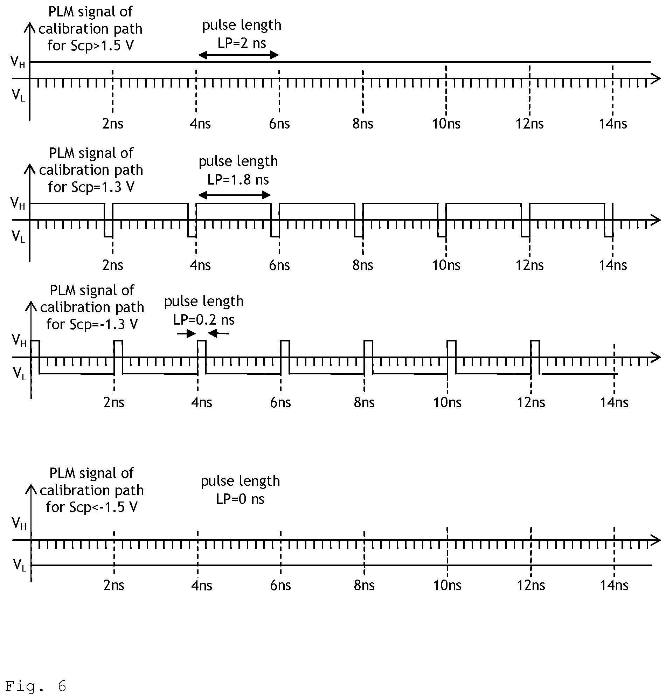

Fig. 6 schematically shows exemplarily pulse length modulated signals Sc_mod of the calibration path of four different precompensated calibration signals Scp according to an embodiment of the invention.

In the first diagram in fig. 6, the pulse length modulated signals Sc_mod with a pulse length LP = 2.0 ns for a DC precompensated calibration signal sequence with Scp > 1.5 V are shown.

In the second diagram in fig. 6, the pulse length modulated signals Sc_mod with a pulse length LP = 1.8 ns for a DC precompensated calibration signal sequence with Scp = 1.3 V are shown.

In the third diagram in fig. 6, the pulse length modulated signals with a pulse length LP = 0.2 ns for a DC precompensated calibration signal sequence with Scp = -1.3 V are shown.

In the fourth diagram in fig. 6, the pulse length modulated signals with a pulse length LP = 0 ns for a DC precompensated calibration signal sequence with Scp < -1.5 V are shown.

It can be seen from the periodic pulses in fig. 6, that the pulse length LP is related to the average power level or the average signal level over several periods of pulses.

E.g. for VL = 0V, measuring the mean power $P_{mean}$ of the periodic pulse length modulated calibration signals Sc_mod while a constant precompensated calibration signal Scp is fed to the second pulse length modulator PLM2 yields a power value which is proportional to the length LP of the corresponding single pulses.

Depicting the measured mean power $P_{mean}$ versus the DC level of the precompensated calibration signal Scp of the calibration path, shows the same characteristics as the diagram in fig. 5, which describes the non-ideal behaviour of the pulse length LP versus the DC level of the precompensated calibration signal Scp.

The maximum achievable mean power is denoted as $P_{max}$, which is e.g. the mean pulse length modulated output power for a precompensated calibration signal with Scp > 1.5 V in the following.

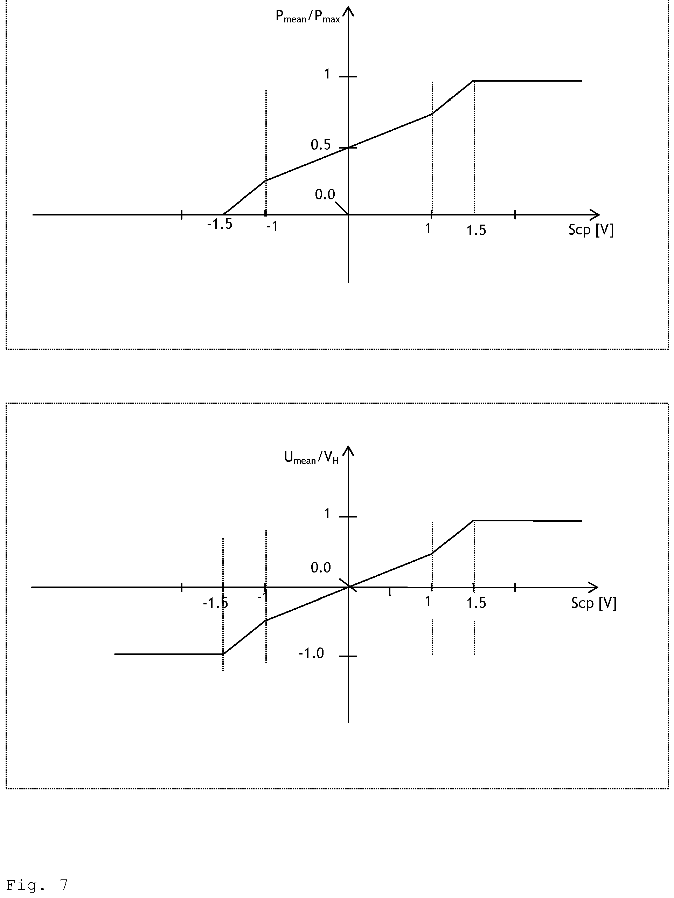

In the upper diagram in fig. 7, the normalized mean power $P_{mean}/P_{max}$ is plotted against the DC level of the precompensated calibration signal Scp.

E.g. for VL = -VH, measuring the mean signal level Mean of the periodic pulse length modulated calibration signals Sc_mod while a constant precompensated calibration signal Scp is fed to the second pulse length modulator PLM2 yields a mean signal value which is linearly proportional to the length LP of the corresponding single pulses.

Depicting the measured mean signal level $U_{mean}$ of the periodic pulse length modulated calibration signals Sc_mod versus the DC level of the precompensated calibration signal Scp of the calibration path, shows the same characteristics as the diagram in fig. 5, which describes the non-ideal behaviour of the pulse length LP versus the DC level of the precompensated calibration signal Scp.

Hence, the characteristic of pulse length LP versus the DC level of the precompensated calibration signal Scp can be derived from the characteristics of $U_{mean}/VH$ versus Scp or $P_{mean}/P_{max}$ versus Scp respectively.

Knowing the characteristics of LP versus Scp, it is trivial to derive the compensation table by means of the scaled, inverse function for Scp in the range -1.5 V < Scp < 1.5.

In the lower diagram in fig. 7, the normalized mean signal level $U_{mean}/VH$ is plotted against the level of the precompensated calibration signal Scp.

As described above, measurement of e.g. power or energy of the pulse length modulated calibration signals Sc_mod gives information on the actual pulse length of the single pulse, which is e.g. LP = 1.8 ns for the precompensated calibration signal Scp = 1.3 V in this example.

LP = 1.8 ns is the target pulse length for the input signal S - 1.6 V. Hence, the table entry for LP = 1.8 ns can be determined or updated such that S = 1.6 V will be mapped to the value Sp = 1.3 V, as given in the lookup table above.

Other extensions or improvements of this example could be to update also other entries of the lookup table, e.g. samples that are close to the value S = 1.6 V, e.g. by means of extrapolation or interpolation.

Further table entries for other pulse lengths LP can be determined or updated in a similar way.

Initially, the lookup table maps the input signals S to the precompensated input signals Sp according a pre-defined formula, e.g. the formula Sp = 1.0*S, as the relation between the input signals S and the precompensated input signals Sp is not yet known. The lookup table is iteratively updated as described above.

A modulation device MOD as depicted in fig. 4 can be used in a switched mode power amplifier as described in the following.

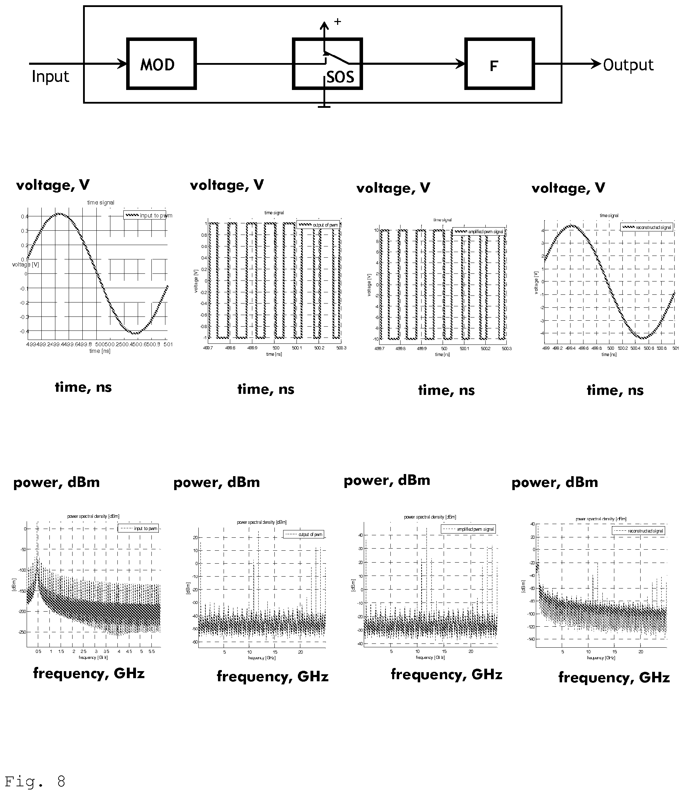

Fig. 8 is illustrating in the upper row schematically such a switched mode power amplifier that comprises a modulation device MOD as depicted in fig. 4, a switched output stage SOS, and a filter F. The switched output stage SOS comprises e.g. a driver and transistors.

The modulation device MOD has an input for receiving input signals. The output of the modulation device MOD is connected to the input of the switched output stage SOS.

The output of the switched output stage SOS is connected to the input of the filter F, and the filter F comprises an output for transmitting output signals.

In the middle row, 4 diagrams are showing the signal voltage in volts versus time in nanoseconds from left to right for signals at the input of the modulation device MOD, at the output of the modulation device MOD, at the output of the switched output stage SOS, and at the output of the filter F.

In the lower row, 4 diagrams are showing the signal power density spectrum in decibels versus frequency in gigahertz from left to right for signals at the input of the modulation device MOD, at the output of the modulation device MOD, at the output of the switched output stage SOS, and at the output of the filter F.

As can be seen from the first two diagrams in the middle row, the modulation device MOD converts analogue signals into digital 2-level signals, and said digital 2-level signals will be transmitted to the switched output stage SOS.

In the third diagram in the middle row, the amplified digital 2-level signal at the output of the switched output stage SOS is shown. In order to convert the amplified digital 2-level signals into amplified analogue signals, the filter F is e.g. a reconstruction filter preferably of low pass or band pass type for converting digital signals into analogue signals. The amplified analogue signal is shown in the last diagram in the middle row.

A base station in a wireless communication network can comprise such a switched mode power amplifier as described above, and an antenna network for transmission of signals over an air interface.

**Claims**

1. A method for pulse length modulation of signals (S) using calibration signals (Sc), said method comprising

   • a step in which the signals (S) are precompensated and pulse length modulated in a data path thereby resulting in modulated signals (S_mod),
   • a step in which the calibration signals (Sc) are pulse length modulated in a calibration path thereby resulting in modulated calibration signals (Sc_mod),

   said method being **characterized by**

   • performing measurements of power or energy of the modulated calibration signals (Sc_mod) in an evaluation path,
   • using said measurements of power or energy of the modulated calibration signals (Sc_mod) to determine pulse lengths of the modulated calibration signals (Sc_mod),
   • performing comparisons of signals modulated using an error-free pulse length modulation in an ideal case using linear sawtooth signals with the calibration signals (Sc) that must be applied to achieve same pulse lengths after modulation in the evaluation path,
   • and using the results of said comparisons to precompensate the signals (S) in said data path.

2. A method according to claim 1, wherein the data path and the calibration path are interchanged by interchanging preprocessors (PP1, PP2) for precompensation and pulse length modulators (PLM1, PLM2) for pulse length modulation.

3. A method according to claim 2, wherein the data path and the calibration path are interchanged by means of a switch.

4. A method according to claim 2 or 3, wherein the data path and the calibration path are interchanged repeatedly.

5. A method according to any of the preceding claims, wherein the calibration signals (Sc) are periodic sequences of equal direct current signals.

6. A method according to any of the preceding claims, wherein the calibration signals (Sc) are sequences of continuous wave signals with varying signal frequency.

7. A method according to any of the preceding claims, wherein the modulated calibration signals (Sc_mod) are used to generate precompensation data stored in a lookup table used to precompensate the signals (S) in the data path.

8. A method according to any of the claims 1 to 6, wherein the modulated calibration signals (Sc_mod) are used to generate a precompensation function used to precompensate the signals (S) in the data path.

9. A method according to any of the preceding claims, wherein the calibration signals (Sc) are selected based on the time passed since the last determination of precompensation values for the different signals (S).

10. A method according to any of the preceding claims, wherein the calibration signals (Sc) are precompensated in the calibration path.

11. A method according to any of the preceding claims, wherein the modulated calibration signals (Sc_mod) are measured by means of at least one of the group of energy measurement, power measurement, and oversampling of the modulated calibration signals (Sc_mod).

12. A modulation device (MOD) for pulse length modulation of signals (S), wherein the modulation device (MOD) comprises at least one processing means which is adapted to

- precompensate and pulse length modulate the signals (S) in a data path resulting in modulated signals (S-mod),
- pulse length modulate calibration signals (Sc) in a calibration path resulting in modulated calibration signals (Sc_mod),

**characterized in that** the at least one processing means is further adapted to:

- perform measurements of power or energy of the modulated calibration signals (Sc_mod) in an evaluation path,
- use said measurements of power or energy of the modulated calibration signals (Sc_mod) to determine pulse lengths of the modulated calibration signals (Sc_mod),
- perform in the evaluation path comparisons of signals modulated using an error-free pulse length modulation in an ideal case using linear sawtooth signals with the calibration signals (Sc) that must be applied to achieve same pulse lengths after modulation,
- and precompensate the signals (S) in said data path based on the results of said comparisons.

13. A modulation device (MOD) according to claim 12, wherein the modulation device (MOD) comprises at least one processing means which is adapted to interchange the data path and the calibration path by interchanging preprocessors (PP1, PP2) for precompensation and pulse length modulators (PLM1, PLM2) for pulse length modulation.

14. A transmitter comprising a modulation device (MOD) for pulse length modulation of signals (S) according to claim 12 and at least one amplifier for amplification of said signals.

15. A base station comprising a transmitter according to claim 14 and at least one antenna network for transmission of said signals over an air interface.


**Patentansprüche**

1. Verfahren zur Pulslängenmodulation von Signalen (S) unter Verwendung von Kalibrierungssignalen (Sc), wobei das besagte Verfahren Folgendes umfasst:

- einen Schritt, bei dem die Signale (S) in einem Datenpfad vorkompensiert und pulslängenmoduliert werden, was zu modulierten Signalen (S_mod) führt,
- einen Schritt, bei dem die Kalibrierungssignale (Sc) in einem Kalibrierungspfad pulslängenmoduliert werden, was zu modulierten Kalibrierungssignalen (Sc_mod) führt, wobei das besagte Verfahren **gekennzeichnet ist durch**
- Durchführen von Messungen der Leistung oder Energie der modulierten Kalibrierungssignale (Sc_mod) in einem Evaluierungspfad,

• Verwenden der besagten Messungen der Leistung oder Energie der modulierten Kalibrierungssignale (Sc_mod) zum Bestimmen von Pulslängen der modulierten Kalibrierungssignale (Sc-mod),

• Durchführen, im Evaluierungspfad, von Vergleichen von Signalen, die unter Verwendung einer fehlerfreien Pulslängenmodulation in einem Idealfall unter Verwendung von linearen Sägezahnsignalen moduliert werden, mit den Kalibrierungssignalen (Sc), die angewendet werden müssen, um gleiche Pulslängen nach der Modulation zu erhalten,

• und Verwenden der Ergebnisse der besagten Vergleiche zum Vorkompensieren der Signale (S) in dem besagten Datenpfad.

2. Verfahren nach Anspruch 1, wobei der Datenpfad und der Kalibrierungspfad ausgetauscht werden durch Austauschen von Vorprozessoren (PP1, PP2) zur Vorkompensation und Pulslängenmodulatoren (PLM1, PLM2) zur Pulslängenmodulation.

3. Verfahren nach Anspruch 2, wobei der Datenpfad und der Kalibrierungspfad ausgetauscht werden mittels eines Schalters.

4. Verfahren nach Anspruch 2 oder 3, wobei der Datenpfad und der Kalibrierungspfad wiederholt ausgetauscht werden.

5. Verfahren nach einem beliebigen der vorstehenden Ansprüche, wobei die Kalibrierungssignale (Sc) periodische Sequenzen von gleichen Gleichstromsignalen sind.

6. Verfahren nach einem beliebigen der vorstehenden Ansprüche, wobei die Kalibrierungssignale (Sc) Sequenzen von Dauerstrich-Signalen mit wechselnder Signalfrequenz sind.

7. Verfahren nach einem beliebigen der vorstehenden Ansprüche, wobei die modulierten Kalibrierungssignale (Sc_mod) verwendet werden, um Vorkampensationsdaten zu erzeugen, die in einer Look-Up-Tabelle gespeichert werden, die zum Vorkompensieren der Signale (S) im Datenpfad verwendet wird.

8. Verfahren nach einem beliebigen der Ansprüche 1 bis 6, wobei die modulierten Kalibrierungssignale (Sc_mod) verwendet werden, um eine Vorkompensationsfunktion zu erzeugen, die zum Vorkompensieren der Signale (S) im Datenpfad verwendet wird.

9. Verfahren nach einem beliebigen der vorstehenden Ansprüche, wobei die Kalibrierungssignale (Sc) ausgewählt werden basierend auf der Zeit, die seit der letzten Bestimmung von Vorkompensationswerten für die unterschiedlichen Signale (S) vergangen ist.

10. Verfahren nach einem beliebigen der vorstehenden Ansprüche, wobei die Kalibrierungssignale (Sc) im Kalibrierungspfad vorkompensiert werden.

11. Verfahren nach einem beliebigen der vorstehenden Ansprüche, wobei die modulierten Kalibrierungssignale (Sc_mod) mithilfe von mindestens einem aus der Gruppe von Energiemessung, Leistungsmessung und Überabtastung der modulierten Kalibrierungssignale (Sc_mod) gemessen werden.

12. Modulationsvorrichtung (MOD) zur Pulslängenmodulation von Signalen (S), wobei die Modulationsvorrichtung (MOD) mindestens ein Verarbeitungsmittel umfasst, das angepasst ist zum

• Vorkompensieren und Pulslängenmodulieren der Signale (S) in einem Datenpfad, was zu modulierten Signalen (S_mod) führt,

• Pulslängenmodulieren von Kalibrierungssignalen (Sc) in einem Kalibrierungspfad, was zu modulierten Kalibrierungssignalen (Sc_mod) führt,

**dadurch gekennzeichnet, dass** das mindestens eine Verarbeitungsmittel weiterhin angepasst ist zum:

• Durchführen von Messungen der Leistung oder Energie der modulierten Kalibrierungssignale (Sc_mod) in einem Evaluierungspfad,

• Verwenden der besagten Messungen der Leistung oder Energie der modulierten Kalibrierungssignale (Sc_mod) zum Bestimmen von Pulslängen der modulierten Kalibrierungssignale (Sc-mod),

• Durchführen, im Evaluierungspfad, von Vergleichen von Signalen, die unter Verwendung einer fehlerfreien Pulslängenmodulation in einem Idealfall unter Verwendung von linearen Sägezahnsignalen moduliert werden, mit den Kalibrierungssignalen (Sc), die angewendet werden müssen, um gleiche Pulslängen nach der Modulation zu erhalten,

• und Vorkompensieren der Signale (S) in dem besagten Datenpfad basierend auf den Ergebnissen der besagten Vergleiche,

13. Modulationsvorrichtung (MOD) nach Anspruch 12, wobei die Modulationsvorrichtung (MOD) mindestens ein Verarbeitungsmittel umfasst, das angepasst ist zum Austauschen des Datenpfads und des Kalibrierungspfads durch Austauschen von Vorprozessoren (PP1, PP2) zur Vorkompensation und Pulslängenmodulatoren (PLM1, PLM2) zur Pulslängenmodulation.

14. Sender, umfassend eine Modulationsvorrichtung (MOD.) zur Pulslängenmodulation von Signalen (S) nach Anspruch 12 und mindestens einen Verstärker zum Verstärken der besagten Signale,

15. Basisstation, umfassend einen Sender nach Anspruch 14 und mindestens ein Antennennetz zur Übertragung der besagten Signale über eine Luftschnittstelle.

## Revendications

1. Procédé pour la modulation d'impulsions en durée de signaux (S) en utilisant des signaux d'étalonnage (Sc), ledit procédé comprenant

   • une étape dans laquelle les signaux (S) sont précompensés et modulés par impulsions de durée variable dans un trajet de données ayant ainsi pour résultat des signaux modulés (S_mod),
   • une étape dans laquelle les signaux d'étalonnage (Sc) sont modulés par impulsions de durée variable dans un trajet d'étalonnage ayant ainsi pour résultat des signaux d'étalonnage modulés (Sc_mod),

   ledit procédé étant **caractérisé par** les étapes suivantes

   • effectuer des mesures de puissance ou d'énergie des signaux d'étalonnage modulés (Sc_mod) dans un trajet d'évaluation,
   • utiliser lesdites mesures de puissance ou d'énergie des signaux d'étalonnage modulés (Sc_mod) pour déterminer des durées d'impulsions des signaux d'étalonnage modulés (Sc_mod),
   • effectuer des comparaisons de signaux modulés en utilisant une modulation d'impulsions en durée sans erreur dans un cas idéal en utilisant des signaux en dents de scie linéaires avec les signaux d'étalonnage (Sc) qui doivent être appliqués pour atteindre les mêmes durées d'impulsions après la modulation dans le trajet d'évaluation,
   • et utiliser les résultats desdites comparaisons pour précompenser les signaux (S) dans ledit trajet de données.

2. Procédé selon la revendication 1, dans lequel le trajet de données et le trajet d'étalonnage sont échangés en échangeant des préprocesseurs (PP1, PP2) pour la precompensation et des modulateurs d'impulsions en durée (PLM1, PLM2) pour la modulation d'impulsions en durée.

3. Procédé selon la revendication 2, dans lequel le trajet de données et le trajet d'étalonnage sont échangés au moyen d'un commutateur.

4. Procédé selon la revendication 2 ou 3, dans lequel le trajet de données et le trajet d'étalonnage sont échangés de façon répétée.

5. Procédé selon l'une quelconque des revendications précédentes, dans lequel les signaux d'étalonnage (Sc) sont des séquences périodiques de signaux à courant continu égaux.

6. Procédé selon l'une quelconque des revendications précédentes, dans lequel les signaux d'étalonnage (Sc) sont des séquences de signaux à ondes continues avec une fréquence de signal variable.

7. Procédé selon l'une quelconque des revendications précédentes, dans lequel les signaux d'étalonnage modulés (Sc_mod) sont utilisés pour générer des données de précompensation stockées dans une table de consultation utilisée pour précompenser les signaux (S) dans le trajet de données.

8. Procédé selon l'une quelconque des revendications 1 à 6, dans lequel les signaux d'étalonnage modulés (Sc_mod) sont utilisés pour générer une fonction de précompensation utilisée pour précompenser les signaux (S) dans le trajet de données.

9. Procédé selon l'une quelconque des revendications précédentes, dans lequel les signaux d'étalonnage (Sc) sont sélectionnés sur la base du temps écoulé depuis la dernière détermination de valeurs de précompensation pour les différents signaux (S).

10. Procédé selon l'une quelconque des revendications précédentes, dans lequel les signaux d'étalonnage (Sc) sont récompensés dans le trajet d'étalonnage.

11. Procédé selon l'une quelconque des revendications précédentes, dans lequel les signaux d'étalonnage modulés (Sc_mod) sont mesurés au moyen d'au moins un du groupe de mesure d'énergie, mesure de puissance, et suréchantillonnage des signaux d'étalonnage modulés (Sc_mod).

12. Dispositif de modulation (MOD) pour la modulation d'impulsions en durée de signaux (S), le dispositif de modulation (MOD) comprenant au moins un moyen de traitement qui est adapté pour

   • précompenser et moduler par impulsions de durée variable les signaux (S) dans un trajet de données ayant pour résultat des signaux modulés (S_mod),
   • moduler par impulsions de durée variable des signaux d'étalonnage (Sc) dans un trajet d'étalonnage ayant pour résultat des signaux d'étalonnage modulés (Sc_mod),

   **caractérisé en ce que** le au moins un moyen de traitement est en outre adapté pour :

   • effectuer des mesures de puissance ou d'énergie des signaux d'étalonnage modulés (Sc_mod) dans un trajet d'évaluation,
   • utiliser lesdites mesures de puissance ou d'énergie des signaux d'étalonnage modulés (8c_mod) pour déterminer des durées d'impulsions des signaux d'étalonnage modulés (Sc-mod),
   • effectuer dans le trajet d'évaluation des comparaisons de signaux modulés en utilisant une modulation d'impulsions en durée sans erreur dans un cas idéal en utilisant des signaux en dents de scie linéaires avec les signaux d'étalonnage (Sc) qui doivent être appliqués pour atteindre les mêmes durées d'impulsions après la modulation,
   • et précompenser les signaux (S) dans ledit trajet de données sur la base des résultats desdites comparaisons.

13. Dispositif de modulation (MOD) selon la revendication 12, le dispositif de modulation (MOD) comprenant au moins un moyen de traitement qui est adapté pour échanger le trajet de données et le trajet d'étalonnage en échangeant des préprocesseurs (PP1, PP2) pour la précompensation et des modulateurs d'impulsions en durée (PLM1, PLM2) pour la modulation d'impulsions en durée.

14. Émetteur comprenant un dispositif de modulation (MOD) pour la modulation d'impulsions en durée de signaux (S) selon la revendication 12 et au moins un amplificateur pour l'amplification desdits signaux.

15. Station de base comprenant un émetteur selon la revendication 14 et au moins un réseau d'antennes pour l'émission desdits signaux sur une interface hertzienne.

Fig. 1

Fig. 2

Pulse length increase due to
non-ideal sawtooth waveform

voltage V

S

Sr_ideal

Sr

Intersection of S and Sr

Splm

VH

VL

time t

LP1    LP2    LP3    LP4

Fig. 3

CTRL_dat

S_mod

S

PP1  Sp  PLM1

data path

SWITCH  S_mod

Sc_mod

evaluation path

Sc  PP2  Scp  PLM2  calibration path

MEAS

Sc_mod

CTRL_mon

EVAL

CTRL_dat    CTRL_mon

MOD

Fig. 4

Fig. 5

Fig. 6

Fig. 7

**voltage, V**   **voltage, V**   **voltage, V**   **voltage, V**

**time, ns**   **time, ns**   **time, ns**   **time, ns**

**power, dBm**   **power, dBm**   **power, dBm**   **power, dBm**

**frequency, GHz**   **frequency, GHz**   **frequency, GHz**   **frequency, GHz**

Fig. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060197590 A1